# EUROPEAN PATENT SPECIFICATION

(11) **EP 3 137 643 B1**
(45) Date of publication and mention of the grant of the patent: **06.05.2020**
(21) Application number: 15786121.2
(22) Date of filing: 09.04.2015
(51) Int. Cl.: C22C 29/02, C23C 4/10, C23C 4/134, B22F 1/00, B22F 1/02, B23K 10/02, C23C 4/06, C22C 19/05, C22C 29/10, C22C 32/00, C22C 33/02, C22C 38/00, C22C 38/34, C22C 38/40, C23C 24/04, C23C 4/131, B23K 103/08, B23K 103/18, B23K 103/00, B23K 103/04

(54) **TITANIUM CARBIDE OVERLAY AND METHOD OF MANUFACTURING THE SAME**
TITANKARBIDDECKSCHICHT UND VERFAHREN ZUR HERSTELLUNG DAVON
REVÊTEMENT DE CARBURE DE TITANE ET PROCÉDÉ DE SA FABRICATION

(30) Priority: 30.04.2014 US 201461986516 P
(43) Date of publication of application: 08.03.2017
(73) Proprietor: Oerlikon Metco (US) Inc., Westbury, NY 11590 (US)
(72) Inventor: FIALA, Petr, Fort Saskatchewan, Alberta T8L 4M9 (CA); CHAVES, Othelo Enojo, Edmonton, Alberta T5Z3L4 (CA); KOZCULAB, Eric, Sherwood Park, Alberta T8H 1P8 (CA)
(74) Representative: Intellectual Property Services GmbH
(86) International application number: PCT/US2015/025055
(87) International publication number: WO 2015/167769

(56) References cited:
- GB-A- 2 076 019
- US-A- 3 254 970
- US-A- 3 886 637
- US-A- 4 615 734
- US-A- 4 704 336
- US-A- 4 704 336
- US-A- 4 806 394
- US-A- 5 145 506
- US-A- 5 145 506
- US-A1- 2007 267 390

## Description

### FIELD OF THE INVENTION

The invention relates to compositions and methods for applying to a surface an overlay comprising titanium carbide.

### BACKGROUND OF THE INVENTION

Several different methods are known for manufacturing a metallic overlay on a substrate, including plasma transferred arc welding (PTA), spray-and-fuse methods, gas tungsten arc welding, gas metal arc welding, and laser cladding. PTA can be used to fuse a metallic coating to a substrate in order to improve its resistance against wear and/or corrosion, a technique also called hardfacing.

In the PTA process, a non-transferred arc is formed between an electrode and the nozzle, and then a transferred arc is formed between the electrode and the workpiece. When the transferred arc is ignited, the workpiece becomes part of the electrical circuit and the plasma arc is directed and focused through the torch orifice onto the workpiece. A powder composition (comprising, e.g., alloys and or carbides) is metered into the nozzle, under a positive pressure gas flow, and onto the workpiece surface, thereby forming a molten deposit that hardens as it cools. By moving the torch and/or workpiece, a weld overlay deposit can be formed on the workpiece.

Titanium carbide (TiC) is material with a high degree of hardness, and so it would be desirable to use TiC in a PTA process. However, TiC is also a very low density material compared to most metals. Therefore, when used in a PTA process, commercially available TiC particles tend to float to the top of the deposit before the deposit cools and hardens. This results in an uneven deposit where TiC is mostly in the top portion, with relatively little in the intermediate portion and adjacent to the workpiece. This effect is exacerbated when thick deposit layers are required, and in multi-pass deposition processes. As a result, TiC for hardfacing is mostly used in fine granular or agglomerated and sintered forms, and generally applied by methods other than PTA or spray/fuse deposition.

U.S. Patent 4,615,734, which is incorporated by reference herein in its entirety, comments on the disadvantageous tendency of TiC to float in PTA applications. The document discloses a composition comprising 30-50 wt% angular TiC, 10-30 % chromium, about 1.5-5% carbon, and the balance essentially iron. The powder is sintered then consolidated onto a surface by hot isostatic pressing.

U.S. Patent 3,725,016, which is incorporated by reference herein in its entirety, forms a hard surface with a composition comprising 10-75% fine TiC powder (e.g., 5-7 µm), 25-90% steel-forming matrix, and other optional components; forming the composition into a slurry; and applying the slurry to a metal substrate by spraying, dipping, or painting; followed by drying. Other compositions comprising TiC particles are generally disclosed by documents GB 2 076 019 A and US 4,806,394.

There remains a need for a method to apply a TiC coating on a substrate by a welding method, such as PTA and spray/fuse deposition. The method is preferably amenable for use with coarse TiC, e.g., particles larger than 45 µm.

There remains a need for uniform substrate hardface coatings comprising TiC, preferably coarse TiC, that can be applied by a welding method such as PTA and spray/fuse deposition.

### SUMMARY OF THE INVENTION

It has surprisingly been found that the floating behavior of TiC, as well as weldability problems, porosity, and process instability, are affected by the morphology, size, and particle density, of the TiC particles. It has been surprisingly found that controlling the morphology and size of the TiC particles permits its use in PTA and spray/fuse deposition processes, and provides a substrate coating having improved homogeneity.

The present invention provides a method of preparing an overlay on a substrate, according to claim 1, the overlay comprising titanium carbide, the method comprising: (a) obtaining a composition comprising TiC particles and non-TiC particles; and (b) applying the composition to a substrate with plasma transferred arc or spray/fuse deposition to form an overlay; wherein the TiC particles sizes are 44-250 micrometers (-60+325 mesh size); wherein the titanium carbide particles comprise 50-100% by weight rounded particles, and 0-50% by weight angular particles, based on weight of TiC; and wherein the TiC comprises 5-70 wt% of the composition, based on weight of TiC and non-TiC particles; wherein the non-TiC particles comprise an alloy and/or a nonmetal.

The present invention also provides a composition, according to claim 7, suitable for plasma transferred arc welding or spray/fuse deposition, the composition comprising TiC particles and non-TiC particles, wherein the TiC particles sizes are 44-250 micrometers (-60+325 mesh size); wherein the titanium carbide particles comprise 50-100% by weight rounded particles, and 0-50% by weight angular particles, based on weight of TiC; and wherein the TiC comprises 5-70 wt% of the composition, based on weight of TiC and non-TiC particles; wherein the non-TiC particles comprise an alloy and/or a nonmetal.

The present invention also provides an overlay comprising titanium carbide particles, according to claim 8.

The composition preferably comprises densified TiC particles, more preferably plasma- densified TiC particles. Preferably, the TiC particles sizes are 63-149 micrometers (-100+230 mesh size). Preferably, the composition is of size 44-250 micrometers (-60+325 mesh size), more preferably of size 63-149 micrometers (-100+230 mesh size).

Preferably, the non-TiC particles comprise an alloy comprising nickel or iron. Preferably, the non-TiC particles comprise a non-metal.

Cladding material preferably includes nickel metal or an alloy comprising nickel. Preferred nickel alloy cladding materials include chromium and/or aluminum.

Preferably, the applying comprises plasma transferred arc welding. Preferably, the overlay comprises homogeneously distributed TiC.

### BRIEF DESCRIPTION OF THE DRAWINGS

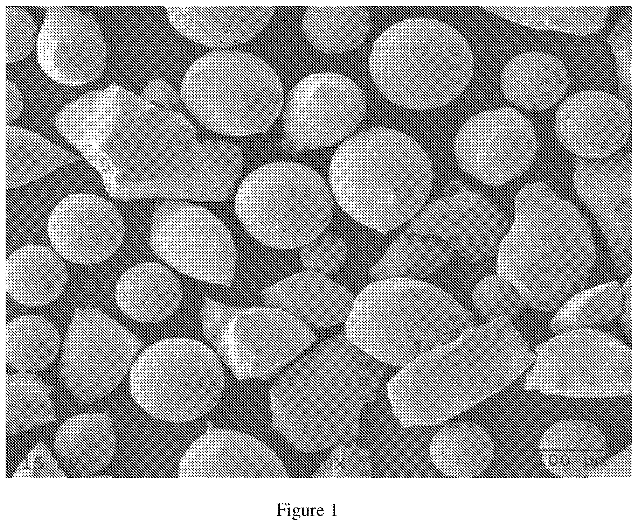

Figure 1 is an SEM photomicrograph, magnification 200x, of a TiC powder useful in the current invention. The reference line is 100 µm.

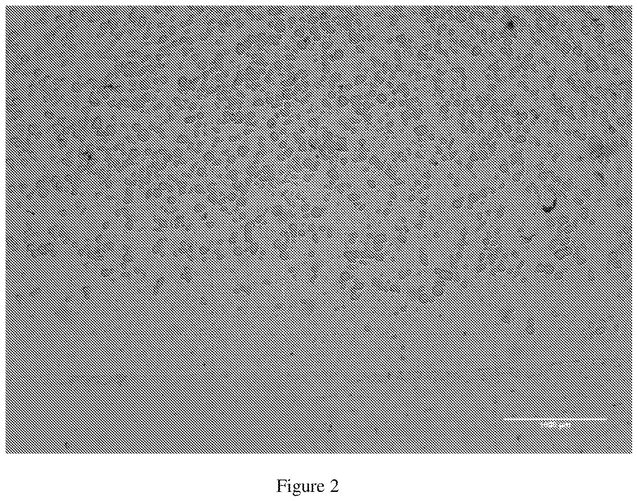

Figure 2 is an OLM photomicrograph, magnification 15x, of a material comprising 32 wt% TiC and 68 wt% Ni self fluxing alloy. The reference line is 1000 µm.
Figure 3 is a photograph of a cross-section of an overlay comprising TiC particles, deposited according to Example 1.
Figure 4 is a photograph of a cross-section of an overlay comprising TiC particles, deposited according to Example 2.
Figure 5 is a photograph of a cross-section of an overlay comprising TiC particles and alloy (30/70 weight ratio), deposited according to Example 3.
Figure 6 is a photograph of a cross-section of an overlay comprising TiC particles and alloy (50/50 weight ratio), deposited according to Example 3.
Figure 7 is a photograph of a cross-section of an overlay comprising TiC particles and alloy (70/30 weight ratio), deposited according to Example 3.
Figure 8 is a photograph of a cross-section of an overlay comprising nickel-clad TiC particles deposited according to Example 4.
Figure 9 is a photograph of a cross-section of an overlay comprising alloy-clad TiC particles deposited according to Example 5.
Figure 10 is a photograph of a cross-section of an overlay comprising alloy-clad TiC particles deposited according to Example 6.

### DETAILED DESCRIPTION OF THE INVENTION

It has been surprisingly found that the floating tendency of titanium carbide can be controlled by controlling the density and morphology of the titanium carbide particles. Rounded (smooth) densified particles of titanium carbide tend to sink in a freshly deposited (non-solidified) layer. On the other hand, it appears that angular particles of densified titanium carbide tend either to float, or to sink slowly enough to set in place as the overlay hardens. It has been unexpectedly found that by using a combination of rounded and angular particles, it is possible to balance these tendencies against each other, thereby obtaining a substantially more uniform distribution of TiC particles, preferably coarse TiC particles, in a hardcoat than previously possible.

The present invention provides a method of coating a substrate with a powder composition comprising titanium carbide. The titanium carbide preferably comprises particles that are rounded, and more preferably also comprises particles that are angular. In addition to titanium carbide, the composition may comprise other components, such as metals, alloys, non-metal, and/or other carbides. The coating method is preferably gas plasma (e.g., plasma transferred arc) or spray/fuse deposition.

TiC is readily commercially available in small particle sizes of several micrometers. Such particles can be agglomerated, for example, by preparing a slurry of TiC particles and an organic binder, injecting the slurry into a spray dryer chamber, and atomizing with a compressed gas. Spherical agglomerates of TiC particles glued together by the binder are collected and may be sintered to remove the binder and increase strength of the agglomerates. Other methods of agglomerating and sintering, or variations of the method described above, are available, including methods known to those having ordinary skill in the art.

While sintering increases strength of TiC agglomerates, the sintered product tends to be porous, which can lead to sintered agglomerate floating in the melt pool. Therefore, the agglomerates are preferably processed to remove pores, thereby making the particles denser. Any method of densification may be used. A preferred method comprises plasma densification. In plasma densification, the agglomerates are injected into an induction plasma where they melt, or partially melt, and then re-solidify into a mix of particles ranging from completely dense and spherical particles to partially melted or un-melted particles with spherical or angular morphology. Induction plasma densification can be carried out, for example, using equipment produced by Tekna Advanced Materials Ltd. It is believed that similar results can be achieved by other methods of densification, for example by methods for making spherical cast tungsten carbide, including methods used routinely by those of ordinary skill in the art. Suitable commercially available products comprising dense rounded particles include TEKMAT TIC-150 and TIC-125 (Tekna Advanced Materials).

Dense TiC particles have a number of other unexpected advantages in addition to reduced floating. The advantages are especially pronounced in PTA or spray/fuse deposition. Dense TiC particles have better particle mechanical properties such as cohesive strength that results in better wear resistance of the hardface. The higher density results in a smaller density difference between TiC and matrix alloy (for example density of Ni alloys are generally about 8-9 g/cm³ depending on alloying elements). The more regular particle shape results in lower drag force and as a result better particle size distribution in an overlay. Dense TiC particles in the sizes discussed below (e.g., at least 45 µm) are especially preferred for their advantageous hardness attributes. The theoretical bulk density of TiC is 4.93 g/cm³. Dense TiC particles in compositions and methods of the present invention preferably have bulk density (including any remaining pores) at least 4 g/cm³, 4.2 g/cm³, 4.4 g/cm³, 4.6 g/cm³, 4.8 g/cm³, or 4.9 g/cm³.

Any source of angular particles of titanium carbide is acceptable. One way of making angular TiC particles is disclosed in U.S. Patent No. 4,615,734. Angular particles can also be made and/or densified using a plasma torch, such as can be obtained from Tekna Plasma Systems, Inc., preferably densified in an inert atmosphere. Angular particles can also be made by other methods, such as by crushing larger TiC particles.

The ratio of rounded to angular TiC may be 100:0, 95:5, 75:25, or 50:50, all ratios being by weight. Ranges formed by any combination of these values are also preferred. Suitable commercially available products include TEKMAT TIC-150 and TIC-125 (Tekna Advanced Materials).

Any TiC particle size can be used. However, if the particles of TiC are too small, this can lead to feeding problems during hardcoat application. Smaller particles may also not provide sufficient wear resistance. On the other hand, particles that are too large may not process properly through a plasma gun. The TiC particles are preferably of suitable size to be capable of application using a PTA or a spray/fuse method. The particles are preferably larger than or about 38 µm, 45 µm, 54 µm, or 64 µm. The particles are preferably smaller than or about 250 µm, 210 µm, 177 µm, 149 µm, 125 µm, 105 µm, 88 µm, or 74 µm. All ranges formed from these values are also preferred, e.g., 44-63 µm, 37-88 µm, etc.

When a TiC particle composition comprises particles wholly or partially outside a desired size range, the composition can be modified to attain the target size range. Any of several sizing methods can be used to obtain the target size range, and can be determined by one of ordinary skill in the art. Some sizing methods can also be used to confirm particle size distribution.

A preferred method comprises using meshes, which can be standardized or non-standardized meshes. Standardized meshes are preferred, and are well known to those of ordinary skill in the art. For example, a 325 mesh allows passage of 44 µm particles, and a 270 mesh allows passage of 53 µm particles. Thus, a -270+325 mesh composition comprises particles in the range of 45-53 µm. Some standardized mesh sizes include 60 (250 µm), 70 (210 µm), 80 (177 µm), 100 (149 µm), 120 (125 µm), 140 (105 µm), 170 (88 µm), 200 (74 µm), 230 (63 µm), 270 (53 µm), 325 (44 µm), and 400 (37 µm). All particle size ranges formed by combinations of mesh sizes, preferably standardized mesh sizes, are suitable. Mesh sizes may be used in a descriptive sense, i.e., without regard to how the particle size distribution of a composition was actually obtained. For example, a particle size distribution of 47-52 µm obtained by any method would satisfy a -270+325 distribution and a -230+325 distribution. Some preferred mesh sizes and/or particle sizes for the present invention include -60+325, more preferably -80+270, yet more preferably -100+230.

In addition to TiC, the powder composition can comprise one or more non-TiC component, i.e., components other than TiC, such as metals, alloys, or non-metals, e.g., as a separate powder, or as a cladding material for TiC particles. Any proportion of these components may be used, and can be determined by one of ordinary skill in the art for a particular application, using this disclosure as a guide. Preferably, the TiC comprises at least 5%, 10%, 15%, 20%, or 25% of the powder composition by weight. Preferably, the TiC comprises up to 70%, 60%, 50%, 40% or 30% of the powder composition by weight.

Metals and/or alloys may also be included in the powder composition, e.g., as a separate powder, or as a cladding material for TiC particles. Some preferred metals include iron, nickel, cobalt, copper, and/or aluminum. Some preferred alloys include alloys of iron, nickel, cobalt, copper, and/or aluminum; more preferably alloys of iron, nickel and/or cobalt; yet more preferably alloys of nickel and/or iron. If iron, nickel, cobalt or copper are alloying elements, their content is preferably up to 50 wt% and/or at least 5 wt%, 10 wt%, or 15 wt% of the alloy. Chromium may also optionally be used, and when used, preferably comprises up to 50 wt%, 40 wt%, or 30 wt% of the alloy, and/or at least 5 wt%, 10 wt%, or 15 wt% of the alloy. Aluminum may optionally be used, and when used, preferably comprises up to 20 wt% of the alloy. Other metals that can be included in the alloys include molybdenum, niobium, vanadium, manganese, and/or titanium, each up to 10 wt% of the alloy.

The alloys may comprise non-metallic components as well. For example, the alloys may comprise carbon (preferably less than 1 wt%), silicon (preferably less than 10 wt%, more preferably less than 5 wt%), boron (preferably less than 10 wt%, more preferably less than 5 wt%), and/or phosphorous (preferably less than 10 wt%, more preferably less than 5 wt%).

The particular alloy used depends on the application, and can be determined by one of skill in the art. Nickel-chromium alloys, stainless steel, and carbon steel are preferred. Some preferred nickel-chromium alloys include commercially available powders such as METCOCLAD, AMDRY, and METCO (all available from Oerlikon Metco). Some suitable stainless steels include the 300 Series (austenitic chromium-nickel steels) such as Type 304 and Type 316; and the 400 Series (ferritic and martensitic chromium steels) such as Type 410, Type 420, and Type 430. Some suitable carbon steels include low-carbon steel with up to 0.3% C (such as AISI 1008, 1010, 1015, 1018, 1020, 1022, 1025), medium carbon steel with 0.3-0.6% C (such as AISI 1030, 1040, 1050, 1060); and high carbon steel with 0.6-0.95% C (such as AISI 1080, 1095), all of which are commercially available from a number of sources.

When used, metals, alloys, and non-metals can comprise any amount of the powder composition. The amount and type of non-TiC component can be determined by one of skill in the art for each application. As a general matter, the non-TiC portion of the powder composition preferably comprises at least 50 wt%, 60 wt%, or 65 wt% of the powder composition, and/or up to 95 wt%, 85 wt%, or 75 wt% of the powder composition.

The alloy powder can have any particle size distribution that permits combining with the TiC powder and application of the overlay. For ease of processing and handling, it is generally preferred that the alloy powder has the same particle size distribution as the TiC powder. For example, as with the TiC powder, a suitable particle size distribution for the alloy powder incudes -60+325, more preferably -80+270, yet more preferably -100+230 mesh sizes.

When titanium carbide particles are cladded, they are preferably cladded with a metal or an alloy. As is well understood in the art, "cladding" refers to application of a material (e.g., metal or alloy) to the surface of another material (e.g., a TiC particle) to form a layer. "Cladding" may also refer to the material to be applied, or to the applied layer. Any metal or alloy may be used for cladding, preferably a metal or alloy that produces a suitable overlay when the composition is applied to a substrate, preferably an overlay having homogeneously distributed TiC. Preferred cladding materials include nickel and nickel alloys.

When cladded TiC particles are used, the TiC particles can be cladded by any method, and can be determined by a person of ordinary skill in the art. One such method employs a Sherritt hydrometallurgical process. When TiC particles are cladded with an alloy, the cladding can be applied directly as an alloy, or the alloy cladding can be applied in stages, e.g., application of a first metal cladding (e.g., nickel), followed by alloying the first metal cladding with another material, such as chromium and/or aluminum. The alloying process can be done by any method, such as a pack cementation method. Pack cementation comprises blending a coarse cladded powder with a fine powder of an alloying metal, and heat treating the blend in a reducing atmosphere, usually above 900° C, until the alloying element diffuses into cladding material and becomes homogenously distributed. It is also common to add an activator, such as a halide, preferably a chloride such as NH₄Cl, to increase the rate of transfer of the alloying metal into the cladding of the composite powder. Such a process is described for example in US Patent 3,914,507, which is incorporated herein by reference in its entirety.

### Examples

### Example 1

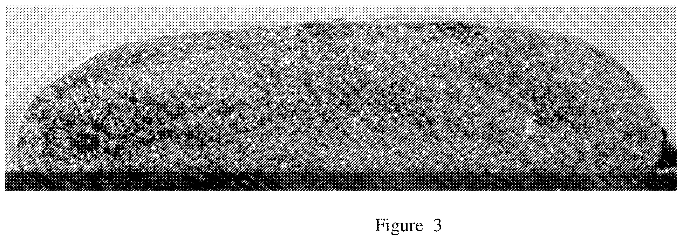

Plasma densified TiC (weight proportion round:angular about 70:30) in a particle range -125+45 micrometers (-120+325 mesh) is blended together with 65wt% of METCOCLAD 625 powder (Oerlikon Metco) in the size range -100+200 mesh. METCOCLAD 625 powder (Oerlikon Metco) is a nickel-based powder with nominal chemistry Ni 21Cr 9Mo 4Nb. This simple mechanical mixture is PTA (Plasma Transferred Arc) deposited on a mild steel substrate. Deposition equipment is STARWELD 400A with EXCALIBUR torch and deposition parameters are: 2 l/min Ar center gas flow, 2 l/min Ar powder gas flow, 12 l/min Ar/H2 shielding gas flow, voltage 29V, current 145A, 43g/min feed rate, oscillation width 22mm, dwell time on each side 0.2s, oscillation speed 1100mm/min, traverse speed 60mm/min, cathode and electrode 1/8". A cross-section of the overlay is shown in Fig. 3.

The overlay is tested according to ASTM G65 for wear resistance, and compared to tool steel D2 standard and the industry PTA standard PLASMADUR 51322 (WC+40wt% NiCrBSi). The results are shown in Table 1.

**Table 1**

| Material | Weight loss (g) |
|---|---|
| Example 1 | 0.027 |
| D2 tool steel | 0.304 |
| PLASMADUR 51322 | 0.029 |

Two of these overlays are also tested on a corrosion-erosion tester under the following test conditions: 3.5%NaCl, 35wt% sand loading, temperature 27° C, 24 hours. Results are shown in Table 2.

**Table 2**

| Material | Erosion-corrosion (mg/cm²/h) | Erosion (mg/cm²/h) |
|---|---|---|
| Example 1 | 0.0166 | 0.0199 |
| PlasmaDur 51322 | 0.0414 | 0.0132 |

### Example 2:

Plasma densified TiC (weight proportion round:angular about 70:30) in a particle range -125+45 micrometers (-120+325 mesh) is blended together with 70wt% of AMDRY 805 powder (Oerlikon Metco) in the size range -140+325 mesh. AMDRY 805 powder (Oerlikon Metco) is an iron based brazing powder with the nominal chemistry Fe 29Cr 18Ni 6P 6Si 0.2RE. The simple mechanical mixture is PTA (Plasma Transferred Arc) deposited on a mild steel substrate. Deposition equipment is STARWELD 400A with EXCALIBUR torch and deposition parameters are: 2 l/min Ar center gas flow, 2 l/min Ar powder gas flow, 12 1/min Ar shielding gas flow, voltage 27V, current 120A, 25g/min feed rate, oscillation width 18mm, dwell time on each side 0.2s, oscillation speed 800mm/min, traverse speed 50mm/min, cathode 1/8" and electrode 3/16".

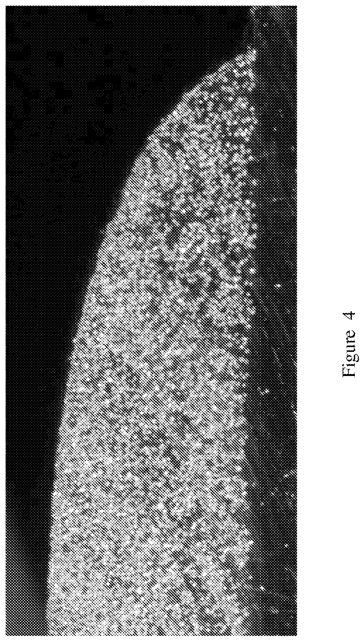

A cross-section of the overlay is shown in Fig. 4. The overlay has an even carbide distribution and good bonding.

### Example 3:

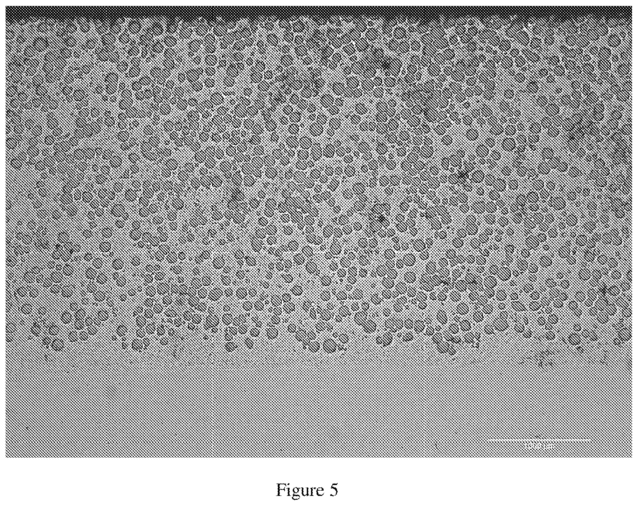

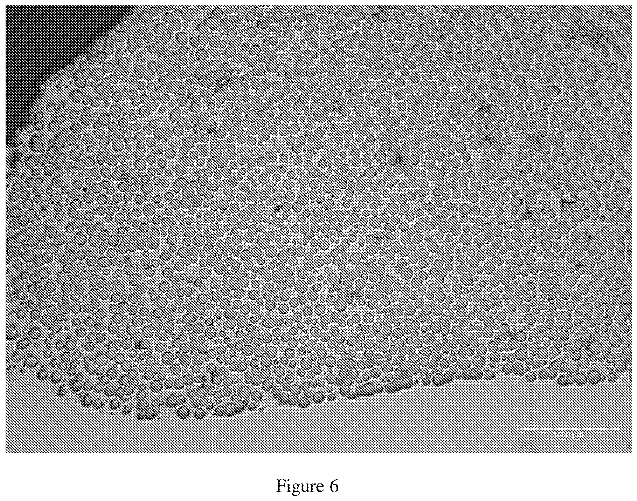

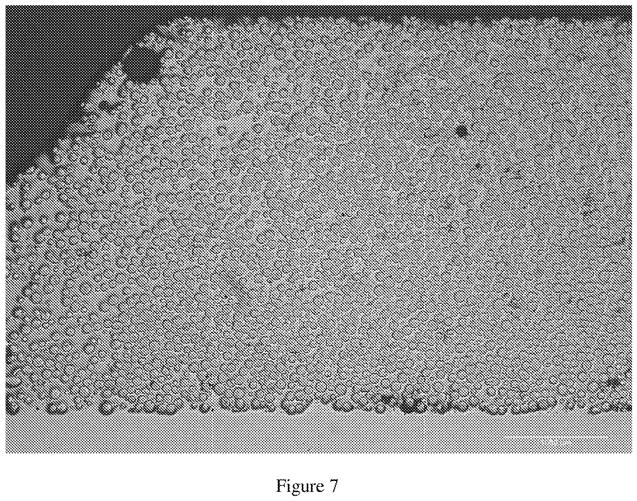

Plasma densified TiC (weight proportion round : angular about 90:10) in a particle range -150+45 micrometers (-100+325 mesh) is blended together with 65wt% total of Metcoclad 316L-Si powder and Fe29Cr17.5Ni6.5Si6P powder alloy in the ratio 30/70, 50/50, and 70/30. Metcoclad 316L-Si powder is a stainless steel 316L based powder with an addition of Si. These blends are PTA (Plasma Transferred Arc) deposited on a mild steel substrate. Deposition equipment is STARWELD 400A with EXCALIBUR torch and deposition parameters are: 2 l/min Ar/H2 center gas flow, 2 l/min Ar powder gas flow, 16 l/min Ar shielding gas flow, voltage 30V, current 140A, 25g/min feed rate, oscillation width 26mm, dwell time on each side 0.2s, oscillation speed 1200mm/min, traverse speed 45mm/min, cathode 3/16", nozzle 1/8" for the 30/70 ratio; 3 1/min Ar/H2 center gas flow, 2 l/min Ar powder gas flow, 16 l/min Ar shielding gas flow, voltage 30V, current 140A, 39g/min feed rate, oscillation width 26mm, dwell time on each side 0.2s, oscillation speed 1000mm/min, traverse speed 50mm/min, cathode 3/16", nozzle 1/8" for the 50/50 ratio; and 3 l/min Ar/H2 center gas flow, 2 l/min Ar powder gas flow, 16 l/min Ar shielding gas flow, voltage 30V, current 120A, 40g/min feed rate, oscillation width 26mm, dwell time on each side 0.2s, oscillation speed 1000mm/min, traverse speed 50mm/min, cathode 3/16", nozzle 1/8" for the 70/30 ratio. Cross-sections of the overlays are shown in Fig. 5, Fig. 6, and Fig. 7 for ratios 30/70, 50/50, and 70/30, respectively.

The overlays are tested according to ASTM G65 for wear resistance, and compared to the industry standard Plasmadur 51322 (WC+40wt%NiCrBSi). The results are shown in Table 3.

**Table 3**

| Material | MC316L/Fe29Cr17.5Ni6.5Si6P | Weight loss (g) |
|---|---|---|
| Example 3 | 30/70 | 0.0547 |
| Example 3 | 50/50 | 0.0506 |
| Example 3 | 70/30 | 0.0444 |
| Plasmadur 51322 | N/A | 0.0217 |

The overlays are also tested to measure characteristics such as hardness, microhardness, and Cr content in matrix. The results are shown in Table 4.

**Table 4**

| Material | MC316L/Fe29Cr17.5Ni6.5Si6P | Hardness HRC | Micro hardness HV0.1 | Average Cr content in powder matrix | Average Cr content in overlay matrix [wt%] |
|---|---|---|---|---|---|
| Example 3 | 30/70 | 52.3 | 390 | 25 | 19.3 |
| Example 3 | 50/50 | 48.3 | 387 | 23 | 15.3 |
| Example 3 | 70/30 | 42.3 | 376 | 21 | 14.4 |
| Plasmadur 51322 | N/A | 58.4 | 496 | 7 | 4 |

The overlays are also tested on a corrosion-erosion tester under the following test conditions: 3.5%NaCl, 35wt% sand loading, temperature 27°C, 24 hours. Results are shown in Table 5.

**Table 5**

| Material | MC316L/Fe29Cr17.5Ni6.5Si6P | Erosion-corrosion (mg/cm²/h) | Erosion (mg/cm²/h) |
|---|---|---|---|
| Example 3 | 30/70 | 0.0110 | 0.0055 |
| Example 3 | 50/50 | 0.0150 | 0.0049 |
| Example 3 | 70/30 | 0.0251 | 0.0085 |
| Plasmadur 51322 | N/A | 0.0378 | 0.0077 |

### Example 4:

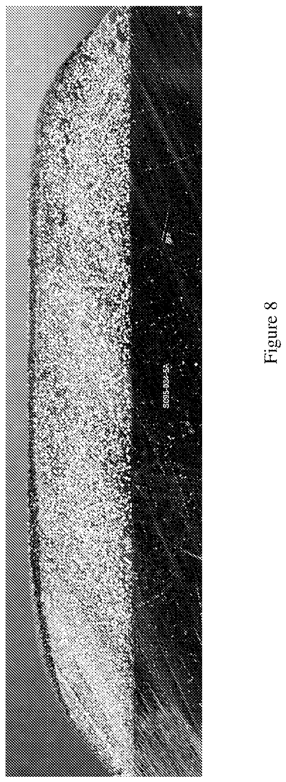

Plasma densified TiC (weight proportion round : angular about 80:20) in a particle range -150+45 micrometers (-100+325 mesh) is suspended in an autoclave and a layer of nickel cladding essentially covering the TiC particle surface is deposited using a Sherritt hydrometallurgical process known to those skilled in the art. Ni cladding comprises 65wt% of composition. This composite powder is PTA (Plasma Transferred Arc) deposited on a mild steel substrate. Deposition equipment is STARWELD 400A with EXCALIBUR torch and deposition parameters are: 2.5 l/min Ar/H2 center gas flow, 2 l/min Ar powder gas flow, 14 l/min Ar shielding gas flow, current 120A, 23.5g/min feed rate, oscillation width 26mm, dwell time on each side 0.1s, oscillation speed 800mm/min, traverse speed 30mm/min, cathode 3/16", nozzle 1/8". A cross-section of the overlay is shown in Fig. 8.

### Example 5:

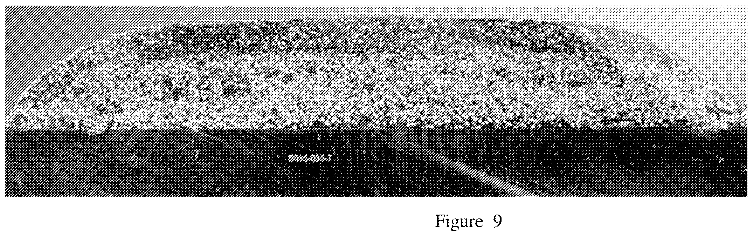

Ni clad TiC powder (e.g., from Example 4) is alloyed with Cr by pack cementation to obtain NiCr cladding with Ni/Cr ratio 80/20 wt%. This alloyed composite powder is PTA (Plasma Transferred Arc) deposited on a mild steel substrate. Deposition equipment is STARWELD 400A with EXCALIBUR torch and deposition parameters are: 2.5 l/min Ar center gas flow, 2 l/min Ar powder gas flow, 16 l/min Ar shielding gas flow, current 100A, voltage 35V, 23.5g/min feed rate, oscillation width 26mm, dwell time on each side 0.1s, oscillation speed 800mm/min, traverse speed 30mm/min, cathode 3/16", nozzle 1/8". A cross-section of the overlay is shown in Fig. 9.

### Example 6:

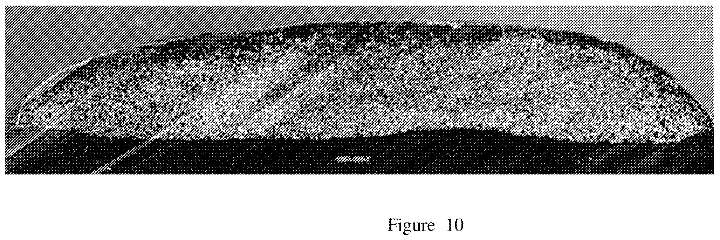

NiCr clad TiC powder (e.g., from Example 5) is further alloyed with Al by pack cementation to obtain NiCrAl cladding with Ni/Cr/Al ratio 73.5/17.8/8.7 wt%. This alloyed composite powder is PTA (Plasma Transferred Arc) deposited on a mild steel substrate. Deposition equipment is STARWELD 400A with EXCALIBUR torch and deposition parameters are: 1.5 l/min Ar center gas flow, 2 l/min Ar powder gas flow, 12 l/min Ar shielding gas flow, current 150A, voltage 30V, 25g/min feed rate, oscillation width 26mm, dwell time on each side 0.1s, oscillation speed 800mm/min, traverse speed 30mm/min, cathode 3/16", nozzle 1/8". A cross-section of the overlay is shown in Fig. 10.

## Claims

1. A method of preparing an overlay on a substrate, the overlay comprising titanium carbide, the method comprising:
(a) obtaining a composition comprising TiC particles and non-TiC particles; and
(b) applying the composition to a substrate by plasma transferred arc welding or spray/fuse deposition to form an overlay;
wherein the TiC particles sizes are 44-250 micrometers (-60+325 mesh size); wherein the TiC particles comprise 50-100% by weight rounded particles, and 0-50% by weight angular particles, based on weight of TiC; and wherein the TiC comprises 5-70 wt% of the composition, based on weight of TiC and non-TiC particles; wherein the non-TiC particles comprise an alloy and/or a non-metal.

2. The method of claim 1, wherein the composition comprises plasma-densified TiC particles.

3. The method of claim 1, wherein the composition is of size 44-250 micrometers (-60+325 mesh size) or of size 63-149 micrometers (-100+230 mesh size).

4. The method of claim 1, wherein the non-TiC particles comprise an alloy comprising nickel or iron or the non-TiC particles comprise a non-metal.

5. The method of claim 1, wherein the applying comprises plasma transferred arc welding.

6. The method claim 1, wherein the overlay comprises homogeneously distributed TiC.

7. A composition suitable for plasma transferred arc welding or spray/fuse deposition, the composition comprising TiC particles and non-TiC particles, wherein the TiC particles sizes are 44-250 micrometers (-60+325 mesh size); wherein the TiC particles comprise 50-100% by weight rounded particles, and 0-50% by weight angular particles, based on weight of TiC; and wherein the TiC comprises 5-70 wt% of the composition, based on weight of TiC and non-TiC particles; wherein the non-TiC particles comprise an alloy and/or a non-metal.

8. An overlay on a substrate, the overlay comprising titanium carbide particles homogeneously distributed in the overlay, wherein the overlay is obtained by applying a composition comprising TiC particles and non-TiC particles by plasma transferred arc welding or spray/fuse deposition to form the overlay;
wherein the TiC particles sizes in the composition are 44-250 micrometers (-60+325 mesh size); wherein the TiC particles in the composition comprise 50-100% by weight rounded particles, and 0-50% by weight angular particles, based on weight of TiC; and wherein the TiC comprises 5-70 wt% of the composition, based on weight of TiC and non-TiC particles; wherein the non-TiC particles comprise an alloy and/or a non-metal.

## Patentansprüche

1. Ein Verfahren zur Herstellung einer Deckschicht auf einem Substrat, wobei die Deckschicht Titancarbid umfasst, wobei das Verfahren umfasst:
a) Erhalten einer Zusammensetzung, die TiC-Partikel und Nicht-TiC-Partikel umfasst; und
b) Aufbringen der Zusammensetzung auf ein Substrat durch Plasma-Pulver-Aufragschweissen oder Sprüh/Schmelzabscheidung zur Bildung einer Deckschicht;
wobei die TiC-Partikelgrössen 44-250 Mikrometer (-60+325 Maschenweite) betragen; wobei die TiC-Partikel 50-100 Gewichtsprozent abgerundete Partikel und 0-50 Gewichtsprozent eckige Partikel umfassen, bezogen auf das Gewicht von TiC; und wobei das TiC 5-70 Gewichtsprozent der Zusammensetzung umfasst, bezogen auf das Gewicht von TiC- und Nicht-TiC-Partikel; wobei die Nicht-TiC-Partikel eine Legierung und/oder ein Nichtmetall umfassen.

2. Das Verfahren nach Anspruch 1, wobei die Zusammensetzung plasmaverdichtete TiC-Partikel umfasst.

3. Das Verfahren nach Anspruch 1, wobei die Zusammensetzung eine Größe von 44-250 Mikrometern (-60+325 Maschenweite) oder eine Größe von 63-149 Mikrometern (-100+230 Maschenweite) aufweist.

4. Das Verfahren nach Anspruch 1, wobei die Nicht-TiC-Partikel eine Legierung umfassen, die Nickel oder Eisen umfasst, oder die Nicht-TiC-Partikel ein Nichtmetall umfassen.

5. Das Verfahren nach Anspruch 1, wobei das Aufbringen Plasma-Pulver-Aufragschweissen umfasst.

6. Das Verfahren nach Anspruch 1, wobei die Deckschicht homogen verteiltes TiC umfasst.

7. Eine Zusammensetzung, die sich für Plasma-Pulver-Aufragschweissen oder Sprüh/Schmelzabscheidung eignet, wobei die Zusammensetzung TiC-Partikel und Nicht-TiC-Partikel umfasst, wobei die TiC-Partikelgrössen 44-250 Mikrometer (-60+325 Maschenweite) betragen; wobei die TiC-Partikel 50-100 Gewichtsprozent abgerundete Partikel und 0-50 Gewichtsprozent eckige Partikel umfassen, bezogen auf das Gewicht von TiC; und wobei das TiC 5-70 Gewichtsprozent der Zusammensetzung umfasst, bezogen auf das Gewicht von TiC- und Nicht-TiC-Partikel; wobei die Nicht-TiC-Partikel eine Legierung und/oder ein Nichtmetall umfassen.

8. Eine Deckschicht auf einem Substrat, wobei die Deckschicht Titancarbid-Partikel umfasst, die homogen in der Deckschicht verteilt sind, wobei die Deckschicht durch Aufbringen einer TiC-Partikel und Nicht-TiC-Partikel umfassenden Zusammensetzung durch Plasma-Pulver-Aufragschweissen oder Sprüh/Schmelzabscheidung zur Bildung der Deckschicht erhalten wird; wobei die TiC-Partikelgrössen in der Zusammensetzung 44-250 Mikrometer (-60+325 Maschenweite) betragen; wobei die TiC-Partikel in der Zusammensetzung 50-100 Gewichtsprozent abgerundete Partikel und 0-50 Gewichtsprozent eckige Partikel umfassen, bezogen auf das Gewicht von TiC; und wobei das TiC 5-70 Gewichtsprozent der Zusammensetzung umfasst, bezogen auf das Gewicht von TiC- und Nicht-TiC-Partikel; wobei die Nicht-TiC-Partikel eine Legierung und/oder ein Nichtmetall umfassen.

## Revendications

1. Un procédé de préparation d'un revêtement sur un substrat, le revêtement comprenant du carbure de titane, le procédé comprenant:
a) obtenir une composition comprenant des particules de TiC et des particules non-TiC; et
b) appliquer la composition sur un substrat par rechargement soudage plasma sous flux en poudre ou par dépôt par pulvérisation/fusion pour former un revêtement;
dans lequel les particules de TiC ont une taille de 44 à 250 micromètres (-60+325 taille de mailles); dans lequel les particules de TiC comprennent 50 à 100 % en poids de particules arrondies, et 0 à 50 % en poids de particules angulaires, sur la base du poids de TiC; et dans lequel le TiC comprend 5-70 % en poids de la composition, sur la base du poids des particules de TiC et de non-TiC; dans lequel les particules non-TiC comprennent un alliage et/ou un non-métal.

2. Le procédé selon la revendication 1, dans lequel la composition comprend des particules de TiC densifiées par plasma.

3. Le procédé selon la revendication 1, dans lequel la composition est de taille 44-250 micromètres (-60+325 taille de mailles) ou de taille 63-149 micromètres (-100+230 taille de mailles).

4. Le procédé selon la revendication 1, dans lequel les particules non-TiC comprennent un alliage comprenant du nickel ou du fer ou les particules non-TiC comprennent un non-métal.

5. Le procédé selon la revendication 1, dans lequel l'application comprend le rechargement soudage plasma sous flux en poudre.

6. Le procédé selon la revendication 1, dans lequel le revêtement comprend du TiC distribué de manière homogène.

7. Une composition adaptée au rechargement soudage plasma sous flux en poudre ou au dépôt par pulvérisation/fusion, la composition comprenant des particules de TiC et des particules non-TiC, dans lequel les particules de TiC ont une taille de 44 à 250 micromètres (-60+325 taille de mailles); dans lequel les particules de TiC comprennent 50 à 100 % en poids de particules arrondies, et 0 à 50 % en poids de particules angulaires, sur la base du poids de TiC; et dans lequel le TiC comprend 5-70 % en poids de la composition, sur la base du poids des particules de TiC et de non-TiC; dans lequel les particules non-TiC comprennent un alliage et/ou un non-métal.

8. Un revêtement sur un substrat, le revêtement comprenant des particules de carbure de titane distribué de manière homogène dans le revêtement, dans lequel le revêtement est obtenu en appliquant une composition comprenant des particules de TiC et des particules de non-TiC par rechargement soudage plasma sous flux en poudre ou par dépôt par pulvérisation/fusion pour former le revêtement; dans lequel les particules de TiC dans la composition ont une taille de 44 à 250 micromètres (-60+325 taille de mailles); dans lequel les particules de TiC dans la composition comprennent 50 à 100 % en poids de particules arrondies, et 0 à 50 % en poids de particules angulaires, sur la base du poids de TiC; et dans lequel le TiC comprend 5-70 % en poids de la composition, sur la base du poids des particules de TiC et de non-TiC; dans lequel les particules non-TiC comprennent un alliage et/ou un non-métal.
